# EUROPEAN PATENT APPLICATION

(11) **EP 3 995 342 A1**
(43) Date of publication of application: **11.05.2022**
(21) Application number: 20205941.6
(22) Date of filing: 05.11.2020
(51) Int. Cl.: B60L 3/00, B60L 3/12, G01R 31/64, H02H 3/32

(54) **MEASUREMENT SYSTEM AND METHOD FOR DETERMINING A STATUS OF A POWER SYSTEM IN A VEHICLE USING THE MEASUREMENT SYSTEM**

(71) Applicant: VOLVO TRUCK CORPORATION, 405 08 Göteborg (SE)
(72) Inventor: NYSTRÖM, Mats, 423 53 Torslanda (SE)
(74) Representative: Kransell & Wennborg KB

(57) **Abstract**

A measurement system (100) for determining safe operating conditions of a high-voltage power system of a vehicle (400), the measurement system comprising: a first voltage measurement unit (102) arranged to measure a first voltage between a positive pole (108) and a negative pole (110) of the power system; a second voltage measurement unit (104) arranged to measure a second voltage between the positive pole and ground (112) of the power system; a third voltage measurement unit (106) arranged to measure a third voltage between a negative pole (106) and ground of the power system; and a measurement system control unit (114) connected to the first, second and third voltage measurement units and configured to compare each of the first, second and third voltage with a corresponding first, second and third voltage threshold value, and if any of the first second or third voltages exceed the corresponding threshold value, provide an indication that a threshold voltage is exceeded.

## Description

### TECHNICAL FIELD

The invention relates to a measurement system and method for determining a status of a power system in an electrical or hybrid vehicle. In particular, the invention relates to a system and method for ensuring the absence of hazardous voltages in a high-voltage system of an electrical vehicle.

The invention is applicable in electrical and hybrid vehicles within the fields of trucks, buses, industrial construction machines and the like. Although the invention will be described with reference to a truck, the invention is not restricted to this particular vehicle, but may also be used in other electric vehicles.

### BACKGROUND

In vehicles comprising electrical or hybrid drive systems, it is important to be able to safely disconnect the high-voltage energy source from the other high-voltage vehicle systems, for example for allowing the vehicle to be serviced and repaired in a secure manner. There are typically ways of manually shutting down or otherwise disconnecting the high-voltage system. However, due to the potentially great hazards of working with a high-voltage system that has not been properly shut down, back-up systems for ensuring that no high-voltage components are accessible to a user are desirable.

Moreover, according to safety standards such as CENELEC - EN 50110, it is required that a secure measurement is performed to confirm the absence of hazardous voltages in the system. Such a secure measurement is often performed by connecting an external device to the vehicle power system and measuring the voltage at a selected location.

One main safety feature of a typical traction voltage system in a vehicle is to have the traction voltage floating with no galvanic connection to the chassis. However, it is not practically possible to have infinite DC isolation resistance between traction voltage lines and the chassis, and this in itself constitute a risk. The DC isolation can be monitored to increase safety, but capacitances are more difficult to avoid, and such capacitances may contain enough energy to be dangerous. Hence, it's important to make sure that capacitances between traction voltage lines and the chassis (for instance decoupling Y-capacitors on electric machine drives) are sufficiently discharged before work on the vehicle traction voltage system is started.

Accordingly, it is desirable to further improve the safety of a high-voltage vehicle system.

### SUMMARY

An object of the invention is to provide a measurement system for determining safe operating conditions of a high-voltage power system in a vehicle to improve the safety in a high-voltage power system by ensuring that there are no hazardous voltages in the system.

According to a first aspect of the invention, there is provided a measurement system for determining safe operating conditions of a high-voltage power system of a vehicle. The measurement system comprises: a first voltage measurement unit arranged to measure a first voltage between a positive pole and a negative pole of the power system; a second voltage measurement unit arranged to measure a second voltage between the positive pole and ground of the power system; a third voltage measurement unit arranged to measure a third voltage between a negative pole and ground of the power system; and a measurement system control unit connected to the first, second and third voltage measurement units and configured to compare each of the first, second and third voltage with a corresponding first, second and third voltage threshold value, and if any of the first second or third voltages exceed the corresponding threshold value, provide an indication that a threshold voltage is exceeded.

The high-voltage power system herein refers to a system for providing electrical power to electrical components of a vehicle. The energy source may be a battery arranged to provide power to an electrical motor for vehicle propulsion, or in the case of a working machine, to an implement of the working machine. The high-voltage system typically operates at voltages over 200V, and often the in the range of 400V to 1000V in order to provide propulsive power for heavy vehicles such as trucks and buses.

The measurement system is arranged to measure both the pole-to-pole voltage as well as pole-to-ground voltages for both poles in order to ensure that there is no hazardous voltage in the system. The measurements are intended to be performed in decommissioned system to provide safety for an operator. An operator can thereby be ensured that a decommissioned system is safe for performing repairs or other maintenance.

According to one embodiment of the invention, the control unit is further configured to compare the second voltage to the third voltage, and if a difference between the second and third voltage is higher than a predetermined voltage difference threshold value, provide an indication that there is a voltage asymmetry. By comparing the two pole-to-pole voltages, i.e. the voltage between the respective negative and positive pole and ground, the measurement system is capable of detecting and characterizing asymmetric isolation faults in the high-voltage power system. There are typically capacitances between both poles and ground in the form of so-called class-Y capacitors which are configured to fail open. However, the capacitances may be charged and discharged differently, with different voltages and at different speeds, in particular when there is a fault such as a short circuit somewhere in the system, which in turn can lead to an asymmetry in the two pole-to-chassis voltages. An asymmetry can also occur if the capacitors have deteriorated such that capacitors have a capacitance which deviates from a nominal value.

Another example of an asymmetric voltage would be if there is a difference in resistance from pole to chassis on positive and negative side, which will lead to a residual voltage when a pole-to-pole discharge is done. Another example is if an isolation monitoring mechanism is aborted during a measurement sequence since it involves active discharge in an asymmetric way.

In a fully functional system, a discharge is typically performed automatically at system shut down. However, in a workshop, defective vehicles are also handled. The system typically comprises means for passive discharge, but which is comparatively quite slow. Regardless of the discharge method, an asymmetric scenario will give a remaining voltage that might be hazardous.

According to one embodiment of the invention, the second and third voltage measurement units are arranged to measure at an energy storage of the high-voltage power system. The energy storage may for example being a battery for providing power to a propulsion system in an electric or hybrid vehicle, and the power system may comprise one or more batteries.

According to one embodiment of the invention, the control unit is further configured to control the first second and third voltage measurement units to repeatedly and simultaneously measure the respective first, second and third voltage. The measurements may for example be performed repeatedly as long as work is being performed, thereby ensuring that an operator is safe when working with the vehicle. The voltage measurement units may for example be configured to repeatedly measure the first, second and third voltages with a fixed interval, wherein the fixed interval is in the range of 10ms to 500ms. By measuring each of the first, second and third voltages simultaneously it can be ensured that an instantaneous system state is characterized.

According to one embodiment of the invention, the first, second and third voltage measurement units are integral parts of a high voltage system of a vehicle. As outlined above, the second and third voltage measurement units, i.e. for measuring the pole to chassis voltages may be voltage measurement units used for measuring an output voltage of the battery. The first voltage measurement unit for measuring the pole-to-pole voltage may be integrated in an electric motor drive unit.

There is also provided a high-voltage power system for a vehicle comprising: a high-voltage energy source; a high-voltage system; and a measurement system and a vehicle comprising such a high-voltage power system according to claim 7.

According to a second aspect of the invention, there is provided a method for determining safe operating conditions of a high-voltage power system in a vehicle using a measurement system. The measurement system comprising: a first voltage measurement unit arranged to measure a first voltage between a positive pole and a negative pole of the power system; a second voltage measurement unit arranged to measure a second voltage between the positive pole and ground of the power system; a third voltage measurement unit arranged to measure a third voltage between a negative pole (106) and ground of the power system; The method comprises: controlling the first, second and third voltage measurement units to measure a respective first, second and third voltage; comparing each of the first, second and third voltage with a corresponding first, second and third voltage threshold value; and if any of the first second and third voltage exceeds the corresponding threshold value, providing an indication that a threshold voltage is exceeded.

Effects and features of this second aspect of the present invention are largely analogous to those described above in connection with the first aspect of the invention.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples.

In the drawings:
Fig. 1 is a schematic illustration of a measurement system for a high-voltage power system in a vehicle according to an embodiment of the invention;
Fig. 2 is a schematic illustration of a measurement system for a high-voltage power system in a vehicle according to an embodiment of the invention;
Fig. 3 is a flow chart outlining a method of controlling a measurement system for a high-voltage power system in a vehicle according to an embodiment of the invention, and
Fig. 4 is a vehicle comprising a measurement system according to an embodiment of the invention.

### DETAILED DESCRIPTION OF EXAMPLE EMBODIMENTS OF THE INVENTION

In the present detailed description, various embodiments of a measurement system for a high-voltage power system according to the present invention are mainly discussed with reference to a power system in a truck. It should however be noted that this by no means limits the scope of the present invention since the described invention is equally applicable in other types of vehicles such as cars, buses and construction vehicles. The described safety circuit may also be used in marine applications such as boats and ships, and in other applications comprising a high-voltage power source and a high-voltage system.

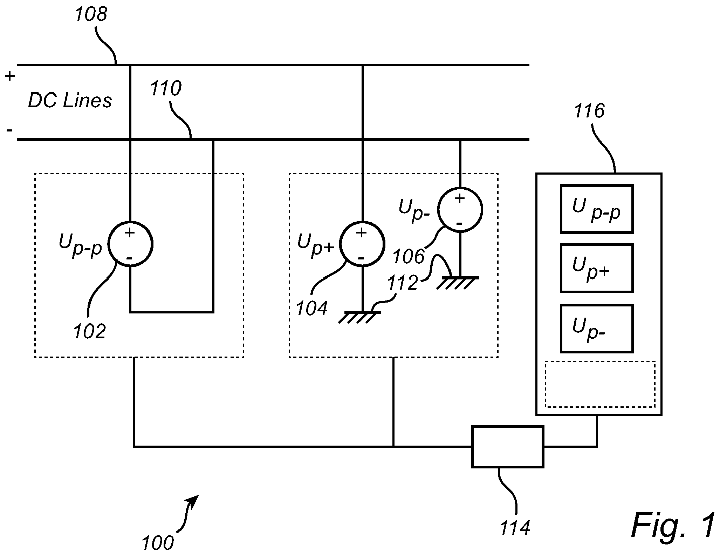

Fig. 1 is a circuit schematic illustrating a measurement system 100 for determining a safe operating conditions of a high-voltage power system in a vehicle. The measurement system comprises a first voltage measurement unit 102, a second voltage measurement unit 104 and a third voltage measurement unit 106. The first voltage measurement unit 102 is arranged to measure a first voltage between a positive pole 108 and a negative pole 110 of the power system. The second voltage measurement unit 104 arranged to measure a second voltage between the positive pole 108 and ground 112 of the power system and the third voltage measurement unit 106 is arranged to measure a third voltage between the negative pole 110 and ground 112 of the power system. The ground potential of the vehicle may be defined by the chassis, and the second and third voltage measurement units 104, 106 are thereby connected between a respective pole and the vehicle chassis.

The measurement system further comprises a measurement system control unit 114 connected to the first, second and third voltage measurement units 102, 104, 106 and is configured to compare each of the first, second and third voltage with a corresponding first, second and third voltage threshold value. If any of the first second or third voltages exceed the corresponding threshold value, an indication is provided that a threshold voltage is exceeded.

The measurement system control unit 114 may include a microprocessor, microcontroller, programmable digital signal processor or another programmable device. The control unit may also, or instead, include an application specific integrated circuit, a programmable gate array or programmable array logic, a programmable logic device, or a digital signal processor. Where the control unit includes a programmable device such as the microprocessor, microcontroller or programmable digital signal processor mentioned above, the processor may further include computer executable code that controls operation of the programmable device. The functionality of the measurement system control unit 114 may also be integrated in one or more general purpose or dedicated ECUs (electronic control units) of the vehicle.

The indication that a threshold voltage is exceeded may for example be provided by a notification unit configured to provide a visual and/or audible indication to an operator. The notification unit may be a separate unit configured to sound an alarm or to flash a light if a threshold voltage is exceeded. A notification may also be provided by a horn, a buzzer, or lights of the vehicle.

As schematically illustrated in Fig. 1, the measurement system 100 may further comprise a display device 116 arranged to be visible to an operator, wherein the display is configured to show the first, second and third voltages. The operator can thus monitor the voltages in person to ensure that the threshold voltages are not exceeded, and that system is safe. The display may be mounted on the vehicle. It is also possible to provide a remote monitoring device where the vehicle sends the measured voltages to an external device. The external device may be a dedicated display device, or it may be provided in the form of functionality integrated in a smartphone, a tablet or the like in the form of an app. Thereby, by providing a notification to a user that a voltage threshold is exceeded, the user can be alerted that there may be a hazardous voltage in the vehicle and appropriate precautions can be taken.

In an example embodiment, the voltage threshold value may be in the range of 30V to 50V, such as 40V. According to current standards for vehicle implementation, it may be required that a system voltage in a decommissioned system does not exceed 60V. However, it may be desirable to set the threshold voltage lower than 60V since also lower voltages can be indicative on a fault in the system. The definition of a safe operating voltage for an operator is the same whether it concerns a pole-to-pole or a pole-to-ground voltage. However, if a capacitor between a pole and ground is large, the capacitor may hold sufficient energy for a harmful discharge also at voltage lower than a safe operating voltage. Accordingly, in some implementations it may desirable to have a voltage threshold value for the pole-to-ground voltage which is lower than a voltage threshold value for the pole-to-pole voltage.

The measurement system control unit 114 is configured to control the first, second and third voltage measurement units 102, 104, 106 to measure a voltage to determine a pole-to-pole voltage, Uₚ₋ₚ, and a respective voltage between the positive and negative poles 108, 110 and ground 112, Uₚ₊, Uₚ₋. The tree voltages may preferably be performed simultaneously. Each voltage is compared to a corresponding threshold voltage, and if any one of the voltages exceed the threshold, an indication is provided by the measurement system control unit 114 to the appropriate vehicle system.

To provide continuous monitoring in order to ensure the safety of the operator also during work on the vehicle, the voltages may be measured or sampled repeatedly, such as ever 10ms. To prevent that the system provides an indication or alert for transient voltages, it may be required that a plurality of consecutive voltages exceed the corresponding voltage threshold value, such as three consecutive voltages.

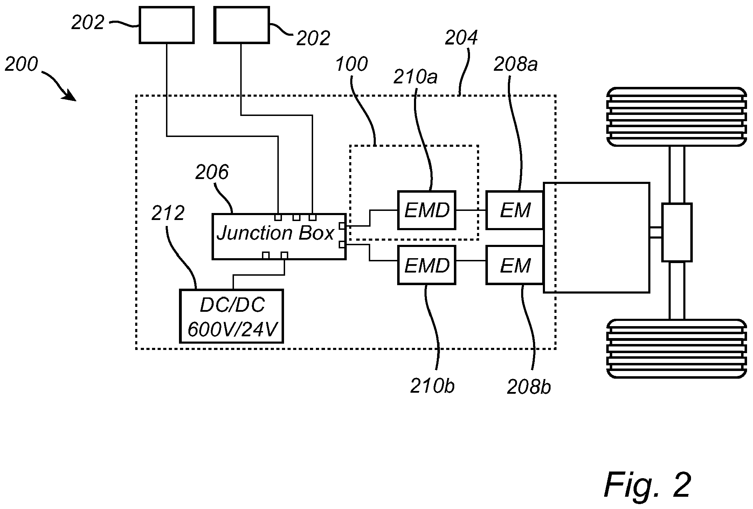

Fig. 2 schematically illustrates an example power system 200 comprising the measurement system 100 described above with reference to Fig. 1. The power system 200 comprises at least one high-voltage energy source 202. In the illustrated example, the high-voltage energy source 202 comprises a plurality of battery packs connected to the high-voltage system 204 via a junction box 206. The high-voltage system 204 is here illustrated as comprising two electrical machines 208a-b for providing vehicle propulsion, each electrical machine being controlled by a corresponding electric motor drive unit 210a-b. A voltage measurement unit for may for example be integrated in the electric motor drive unit 210a-b. A voltage measurement unit may also be integrated in a DC-DC converter 212 of the high voltage system.

Moreover, the pole-to-chassis measurements which are compared to corresponding threshold voltages may be performed both at batteries 202 of the system and/or centrally for the whole high-voltage system. A central voltage measurement may for example be performed by a traction voltage monitoring unit (TVMU).

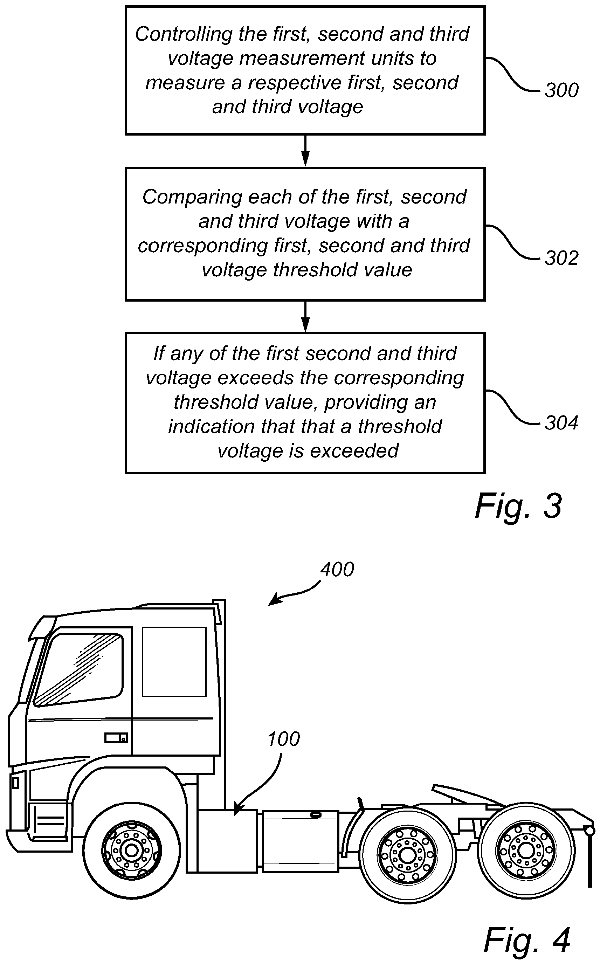

Fig. 3 is a flow chart outlining the general steps of a method which may be performed by the above described measurement system control unit 110. The method comprises controlling 300 the first, second and third voltage measurement units 102, 104, 106 to measure a respective first, second and third voltage Uₚ₋ₚ, Uₚ₊, Uₚ₋, and comparing 302 each of the first, second and third voltages with a corresponding first, second and third voltage threshold value. If any of the first second and third voltage exceeds the corresponding threshold value, an indication is provided 304 that a threshold voltage is exceeded.

Fig. 4 is a vehicle 400 comprising a measurement system 100 for a power system according to any of the aforementioned embodiments and examples.

It is to be understood that the present invention is not limited to the embodiments described above and illustrated in the drawings; rather, the skilled person will recognize that many changes and modifications may be made within the scope of the appended claims.

## Claims

1. A measurement system (100) for determining safe operating conditions of a high-voltage power system of a vehicle (400), the measurement system comprising:
a first voltage measurement unit (102) arranged to measure a first voltage between a positive pole (108) and a negative pole (110) of the power system;
a second voltage measurement unit (104) arranged to measure a second voltage between the positive pole and ground (112) of the power system;
a third voltage measurement unit (106) arranged to measure a third voltage between the negative pole and ground of the power system; and
a measurement system control unit (114) connected to the first, second and third voltage measurement units and configured to compare each of the first, second and third voltage with a corresponding first, second and third voltage threshold value, and if any of the first second or third voltages exceed the corresponding threshold value, provide an indication that a threshold voltage is exceeded.

2. The measurement system according to claim 1, wherein the control unit is further configured to compare the second voltage to the third voltage, and if a difference between the second and third voltage is higher than a predetermined voltage difference threshold value, provide an indication that there is a voltage asymmetry.

3. The measurement system according to claim 1 or 2, wherein the second and third voltage measurement units are arranged to measure at an energy storage of the high-voltage power system.

4. The measurement system according to any one of the preceding claims, wherein the control unit is further configured to control the first second and third voltage measurement units to repeatedly and simultaneously measure the respective first, second and third voltage.

5. The measurement system according to claim 4, wherein the control unit is further configured to control the first, second and third voltage measurement units to repeatedly measure the respective first, second and third voltage with a fixed interval, wherein the fixed interval is in the range of 10ms to 500ms.

6. The measurement system according to any one of the preceding claims, wherein the first, second and third voltage measurement units are integral parts of a high voltage system of a vehicle.

7. A high-voltage power system (200) for a vehicle comprising:
a high-voltage energy source (202);
a high-voltage system (204); and
a measurement system (100) according to any one of the preceding claims.

8. A vehicle (400) comprising a high-voltage power system according to claim 7.

9. Method for determining safe operating conditions of a high-voltage power system (200) in a vehicle (400) using a measurement system (100), the measurement system comprising:
a first voltage measurement unit (102) arranged to measure a first voltage between a positive pole (108) and a negative pole (110) of the power system;
a second voltage measurement unit (104) arranged to measure a second voltage between the positive pole and ground (112) of the power system;
a third voltage measurement unit (106) arranged to measure a third voltage between the negative pole and ground of the power system; wherein the method comprises:
controlling (300) the first, second and third voltage measurement units to measure a respective first, second and third voltage;
comparing (302) each of the first, second and third voltage with a corresponding first, second and third voltage threshold value; and
if any of the first second and third voltage exceeds the corresponding threshold value, providing (304) an indication that a threshold voltage is exceeded.

10. The method according to claim 9, further comprising comparing the second voltage to the third voltage, and if a difference between the second and third voltage is higher than a predetermined voltage difference threshold value, providing an indication that there is a voltage asymmetry.

11. The method according to claim 9 or 10, further comprising simultaneously measuring the first, second and third voltages.

12. The method according to any one of claims 9 to 11, further comprising measuring the respective first, second and third voltages repeatedly and with a fixed interval.

13. The method according to any one of claims 9 to 12, further comprising providing an indication that a threshold voltage is exceeded only if a predetermined number of consecutive measured voltages exceed the corresponding voltage threshold value.

14. The method according to any one of claims 9 to 13, further comprising determining that the vehicle power system is in a passive state.

15. The method according to any one of claims 9 to 14, further comprising, if any of the first, second or third voltages exceed the corresponding threshold value, providing a visual and/or audible alert to notify an operator that the high-voltage power system is unsafe.
